Europäisches Patentamt

European Patent Office

Office européen des brevets

(19)

(11) Numéro de publication : **0 329 525 B1**

(12) **FASCICULE DE BREVET EUROPEEN**

(45) Date de publication du fascicule du brevet :
28.04.93 Bulletin 93/17

(51) Int. Cl.⁵ : **H03J 7/02, H03J 7/08**

(21) Numéro de dépôt : **89400337.5**

(22) Date de dépôt : **07.02.89**

(54) **Filtre auto-adaptatif commutable pour poste émetteur et/ou récepteur radio.**

(30) Priorité : **17.02.88 FR 8801859**

(43) Date de publication de la demande :
**23.08.89 Bulletin 89/34**

(45) Mention de la délivrance du brevet :
**28.04.93 Bulletin 93/17**

(84) Etats contractants désignés :
**DE GB IT**

(56) Documents cités :
**DE-A- 1 941 710
DE-A- 3 146 036
DE-A- 3 231 708
DE-A- 3 236 162
FR-A- 2 582 170
US-A- 4 466 133**

(73) Titulaire : **THOMSON-CSF
51, Esplanade du Général de Gaulle
F-92800 Puteaux (FR)**

(72) Inventeur : **Trumpff, Jean-Michel
THOMSON-CSF SCPI
F-92045 PARIS LA DEFENSE CEDEX 67 (FR)**
Inventeur : **Byzery, Michel
THOMSON-CSF SCPI
F-92045 PARIS LA DEFENSE CEDEX 67 (FR)**
Inventeur : **Raineteau, Gilles
THOMSON-CSF SCPI
F-92045 PARIS LA DEFENSE CEDEX 67 (FR)**

(74) Mandataire : **Lincot, Georges et al
THOMSON-CSF, SCPI, B.P. 329, 50, rue
Jean-Pierre Timbaud
F-92402 Courbevoie Cédex (FR)**

**Description**

La présente invention concerne un filtre auto-adaptatif commutable pour poste émetteur et/ou récepteur radio.

Elle s'applique notamment à la réalisation de filtres commutables en évasion de fréquence.

Dans les techniques connues de réalisation des filtres radiofréquence, l'obtention d'un fonctionnement n'exigeant qu'une faible consommation de courant sans que la fréquence d'accord du filtre soit modifiée en présence d'un signal brouilleur tout en garantissant une bonne agilité en fréquence, répond à des exigences contradictoires.

Une première catégorie de filtres concerne les filtres accordés par poids de capacités commutés au moyen de diodes PIN. Pour garantir une bonne agilité en fréquence les commutations s'effectuent au niveau des circuits accordés. Cependant de fortes valeurs de courant sont utilisées pour polariser les diodes afin de ne pas amortir les circuits résonnants du filtre par des termes résistifs importants et garantir une bonne immunité aux signaux brouilleurs.

Une deuxième catégorie de filtres concerne les filtres accordés par poids de capacités commutés par des relais électromécaniques. Ces filtres consomment beaucoup d'énergie lorsque leur fréquence d'accord est souvent modifiée et ne permettent pas d'obtenir une grande agilité en fréquence.

Une troisième catégorie concerne les filtres passe-bande commutés par diodes PIN. Ces filtres réclament un grand nombre de cellules passe-bandes pour obtenir une bonne sélectivité. Comme les précédents ils consomment beaucoup de courant et présentent l'inconvénient d'occuper une place importante en volume dans les équipements.

Enfin la quatrième catégorie concerne les filtres accordés par diodes varicap qui autorisent une bonne agilité en fréquence avec une faible consommation. De tels filtres sont par exemple décrits dans la demande de brevet allemand DE 3 146 036 A1. Malheureusement, en présence de brouilleurs provoqués par des postes émetteurs situés à proximité, la tension de polarisation des diodes varicap est perturbée provoquant le désaccord des filtres.

Le but de l'invention est de pallier les inconvénients précités.

A cet effet, l'invention a pour objet un filtre auto-adaptatif commutable pour poste émetteur radio et/ou récepteur du type comprenant un circuit de filtrage à diodes varicap selon la revendication 1. Il comprend notamment un circuit de réaction pour stabiliser la fréquence d'accord $f_o$ du filtre en agissant sur la tension et le courant de polarisation des diodes varicap lorsque des signaux brouilleurs ont une fréquence située dans la bande passante du filtre.

L'invention a pour principal avantage qu'elle permet, grâce à la correction de la tension qui est appliquée aux diodes varicap, de maintenir le filtre calé sur sa fréquence d'accord qui peut ainsi conserver une bonne tenue aux signaux brouilleurs provoqués par des postes émetteurs situés à proximité. D'autre part, le système de correction utilisé permet de n'appliquer la tension de correction que s'il y a effectivement décalage de l'accord du filtre permettant ainsi d'éliminer automatiquement les brouilleurs forts très proches de l'accord du filtre. D'autre part, le fait, que la détection du niveau de brouillage s'effectue après le dispositif de filtrage à varicap et après amplification, permet de ne détecter que les brouilleurs forts proches de l'accord du filtre. Egalement, la détection après amplification est plus facile à mettre en oeuvre et n'amortit pas le filtre accordé.

D'autres caractéristiques et avantages de l'invention apparaîtront ci-après à l'aide de la description faite en regard des dessins annexés qui va suivre et qui représentent :

- la figure 1 un filtre auto-adaptatif selon l'invention ;
- la figure 2 un mode de réalisation du circuit de filtrage à diodes varicap du filtre auto-adaptatif représenté à la figure 1 ;
- la figure 3 un mode de réalisation du circuit additionneur du filtre auto-adaptatif représenté à la figure 1.

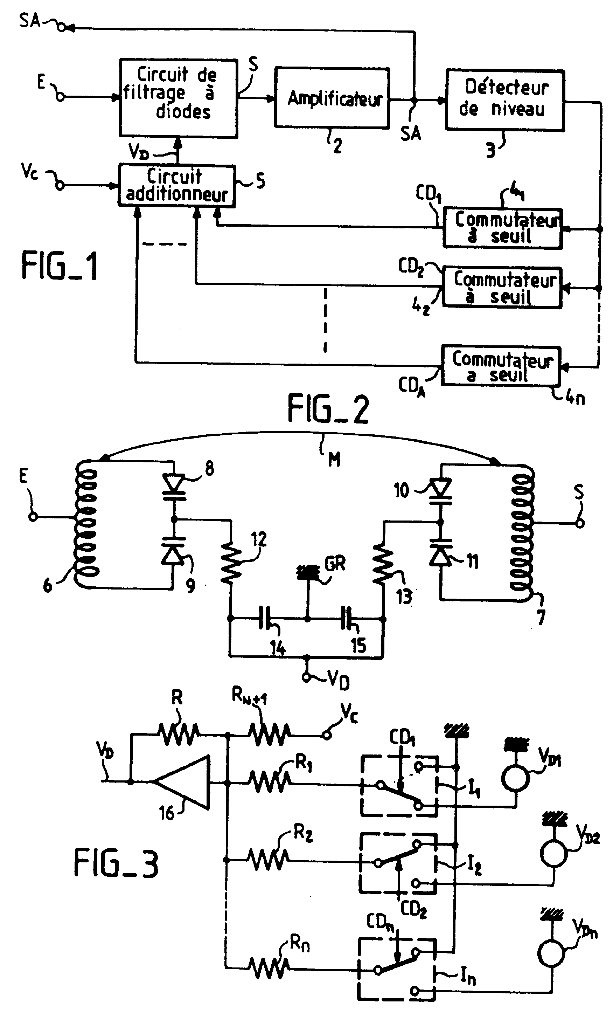

Le filtre auto-adaptatif selon l'invention représenté à la figure 1 comprend un circuit de filtrage à diodes varicap 1 couplé à un amplificateur 2 et à un détecteur de niveau 3. L'amplificateur 2 et le détecteur de niveau 3 sont reliés dans cet ordre en série à l'entrée d'un ensemble de n commutateurs à seuil référencées respectivement de $4_1$ à $4_n$. Les commutateurs $4_1$ à $4_n$ délivrent sur leurs sorties des signaux de commande $CD_1$ à $CD_n$ sur des entrées de commande d'un circuit de calcul 5 dont la fonction est de fournir une tension $V_D$ de commande de la fréquence d'accord du circuit de filtrage à diodes varicap 1.

Le circuit de filtrage à diodes varicap 1 qui est représenté à la figure 2 comprend un ensemble de deux circuits résonnants parallèles formés par deux selfs 6 et 7 accordées respectivement par deux diodes varicap 8-9 et 10-11. Les selfs 6 et 7 sont couplées entre elles par mutuelle induction. Leur coefficient de mutuelle induction M est symbolisé sur la figure 2. Les diodes 8-9 et 10-11 sont montées tête-bêche en série entre les extrémités des selfs 6 et 7, et ont leur extrémité commune reliées au circuit de masse GR du filtre au travers respectivement d'une résistance 12-13 et d'un condensateur 14 et 15. Les extrémités non communes des résistances 12 et 13 avec les diodes 8-9 et 10-11 sont reliées à la sortie du circuit additionneur 5 de la figure 1 fournissant la tension de commande $V_D$ de l'accord du filtre. L'enroulement de la self 6 comprend un point milieu sur lequel est appliqué le signal E à filtrer. La self 7 comprend également un point milieu S qui est relié à l'entrée de l'amplificateur 2 de la figure 1.

Le circuit de calcul 5 est représenté à la figure 3. Il se compose d'un amplificateur opérationnel 16 monté en circuit additionneur de tension au moyen d'une résistance de contre-réaction R et N+1 résistances d'addition référencées respectivement de $R_1$ à $R_{N+1}$. Les tensions à additionner sont appliquées au moyen des commutateurs $4_1$ à $4_n$ fournissant les signaux de commande $CD_1$ à $CD_n$, à des interrupteurs $I_1$ à $I_n$ qui appliquent respectivement sur l'extrémité non commune des résistances R1 à $R_n$ un potentiel de zéro volt ou un potentiel $VD_i$ où l'indice i est compris entre 1 et n. Enfin sur la figure 3 l'extrémité non commune à la résistance $R_{n+i}$ et aux résistances $R_1$ à $R_n$ reçoit une tension $V_c$ correspondant à la fréquence d'accord d'accord $f_o$ du filtre en l'absence de signal brouilleur.

En évasion de fréquence la tension $V_c$ est constamment modifiée par paliers successifs, pour permettre l'accord du filtre sur chaque nouvelle fréquence.

En l'absence de signal brouilleur le circuit de filtrage à diode varicap qui est représenté à la figure 2 délivre une tension voisine de zéro à la sortie S formant le point milieu de l'enroulement 7. En présence de signaux brouilleurs proches de la fréquence $f_o$ d'accord du filtre des tensions sont développées aux bornes des diodes varicap 8 à 11 qui déséquilibrent l'accord du filtre. Cependant à cause de la sélectivité de ce dernier seuls les signaux brouilleurs proches de la fréquence $f_o$ développent des tensions significatives en sortie S de l'enroulement 7 et donc en sortie SA de l'amplificateur 2 de réception. Ces signaux sont détectés par le détecteur de niveau 3 qui selon leurs niveaux, positionne les commutateurs à seuil $4_1$ à $4_n$ en appliquant les signaux de commande $CD_1$ à $CD_n$ sur les interrupteurs $I_1$ à $I_n$ du circuit de calcul de la figure 3. Ces commandes permettent d'élaborer la tension $V_D$ en ajoutant à la tension $V_c$ de commande de la fréquence d'accord du filtre sans brouilleurs des échelons de tension $VD_i$ tels que la relation

$$V_D = V_c - \sum_{i=1}^{n} VD_i$$

soit vérifiée.

Les échelons de tension pallient à la diminution apparente de la tension de commande VC provoquée par les brouilleurs proches et l'utilisation des commutateurs à seuil $4_1$ à $4_n$ permet d'obtenir des états de commande $CD_1$ à $CD_n$ stables.

**Revendications**

1. Filtre auto-adaptatif commutable pour poste émetteur et/ou récepteur radio du type comprenant un circuit de filtrage (1) à diodes varicap (8, 9, 10, 11) caractérisé en ce qu'il comprend un circuit de réaction (2, 3, $4_1...4_n$, 5) pour stabiliser la fréquence d'accord $f_o$ du filtre en agissant sur la tension et le courant de polarisation des diodes varicap (8, 9, 10, 11) lorsque des signaux brouilleurs ont une fréquence située dans la bande passante du filtre et en ce que le circuit de réaction (2, 3, $4_1...4_n$) comprend un détecteur de niveau (3) couplé à la sortie du circuit de filtrage (1) pour détecter le niveau du signal brouilleur et commander un circuit de calcul (5) comprenant un circuit additionneur (5) pour ajouter des niveaux de tension déterminés en fonction du niveau du signal brouilleur détecté par le détecteur de niveau (3) et appliquer le niveau de tension résultant sur les diodes varicap du circuit de filtrage pour stabiliser le filtre auto-adaptatif sur sa fréquence $f_o$.

**Patentansprüche**

1. Selbstanpassendes umschaltbares Filter für einen Funksender und/oder Funkempfänger mit einem Varicap-Dioden (8, 9, 10, 11) enthaltenden Filterkreis (1), dadurch gekennzeichnet, daß es einen Rückkopplungskreis (2, 3, $4_1 ... 4_n$, 5) zur Stabilisierung der Abstimmfrequenz $f_o$ des Filters aufweist, indem auf die Vorspannung und den Strom der Varicap-Dioden (8, 9, 10, 11) eingewirkt wird, wenn Störsignale eine Frequenz haben, die im Durchlaßband des Filters liegt, und daß der Rückkopplungskreis (2, 3, $4_1 ... 4_n$) einen Pegeldetektor (3) aufweist, der an den Ausgang des Filterkreises (1) gekoppelt ist, um den Pegel des Störsignals zu erfassen und einen Rechenkreis mit einem Addierkreis (5) zu steuern, um abhängig vom Pegel des durch den Pegeldetektor (3) erfaßten Störsignals bestimmte Spannungspegel hinzuzufügen und den resultierenden Spannungspegel an die Varicap-Dioden des Filterkreises zur Stabilisierung des selbstanpassenden Filters auf seiner Frequenz $f_o$ anzulegen.

**Claims**

1. A variable self-adapting filter for a radio transmitting and/or receiving station of the type comprising a smoothing circuit (1) with varicap diodes (8, 9, 10, 11), characterised in that it comprises a feedback circuit (2, 3, $4_1 ... 4_n$, 5) for stabilising the tuned frequency $f_o$ of the filter while acting on the bias voltage and current of the varicap diodes (8, 9, 10, 11) when unwanted signals have a frequency situated within the pass-band of the filter, and in that the feedback circuit (2, 3, 4, ... 4) comprises a level detector (13) coupled to the output of the smoothing circuit (1) in order to detect the level of the unwanted signal and control a calculation circuit (5) comprising an adder circuit (5) for adding given voltage levels as a function of the level of the unwanted signal detected by the level detector (3) and applying the resulting voltage level to the varicap diodes of the smoothing circuit in order to stabilise the self-adapting filter to its frequency $f_o$.

EP 0 329 525 B1

SA

E
Circuit de filtrage à diodes
S
Amplificateur
SA
Détecteur de niveau
2
3

Vc
Circuit additionneur
5
VD

CD₁
Commutateur à seuil
4₁

CD₂
Commutateur à seuil
4₂

CDₐ
Commutateur a seuil
4n

FIG_1

FIG_2

E
8
M
10
S
6
9
12
GR
13
11
7
14
15
VD

R   R_{N+1}   Vc
CD₁
V_{D1}

VD
16
R₁
I₁

R₂
I₂
CD₂
V_{D2}

FIG_3
CDₙ
Rₙ
Iₙ
V_{Dn}

5